# EUROPÄISCHE PATENTANMELDUNG

(11) **EP 1 562 154 A1**
(43) Veröffentlichungstag der Anmeldung: **10.08.2005**
(21) Anmeldenummer: 04030106.1
(22) Anmeldetag: 20.12.2004
(51) Int. Cl.: G07D 7/02, G07F 7/08, H01L 51/40, H01L 51/30, H01B 1/12, B42D 15/00, D21H 21/40, D21H 21/48, C08G 61/12

(54) **Ssubstrate mit elektrisch leitfähigen Polymerschichten aus Polythiophen oder dessen Derivaten**

(30) Priorität: 29.12.2003 AT 20912003
(71) Anmelder: Hueck Folien Ges.m.b.H, 4342 Baumgartenberg (AT)
(72) Erfinder: Bergsmann, Martin, Dr., 4020 Linz (AT); Kastner, Friedrich, Dr., 4710 Grieskirchen (AT); Wagner, Eveline, Dipl.Ing., 1090 Wien (AT)
(74) Vertreter: Landgraf, Elvira, Dipl.-Ing.

(57) **Zusammenfassung**

Die Erfindung betrifft Substrate mit elektrisch leitfähigen Schichten, wobei die elektrisch leitfähigen Schichten aus elektrisch leitfähigen Polymeren bestehen. Die elektrisch leitfähigen Polymeren können gegebenenfalls in Gegenwart anderer elektrisch leitfähiger und/oder funktioneller und/oder dekorativer Schichten auf dem Substrat vorhanden sein.

Die Substrate werden insbesondere unter anderem als Sicherheitselemente, als Bauelemente in der Elektronikindustrie und als dekorative Elemente verwendet.

## Beschreibung

Die Erfindung betrifft Substrate mit elektrisch leitfähigen Schichten, die für technische Anwendungen beispielsweise Displayfronten und dergleichen geeignet sind, Verfahren und eine Vorrichtung zu deren Herstellung und deren Verwendung.

Bei der Herstellung von beschichteten Substraten werden üblicherweise leitfähige Farben oder Lacke zum Drucken elektrisch leitfähiger Schichten verwendet. Den Farben oder Lacken werden dabei im allgemeinen elektrisch leitfähige Pigmente, beispielsweise Russ, Graphit, Silber und dergleichen zugemischt. Allerdings sind die mit diesen Pigmenten versehenen Farben und Lacke nach dem Drucken, insbesondere auch auf transparenten Substraten deutlich sichtbar.
Bei verschiedenen Anwendungen ist es jedoch unerwünscht, dass die aufgebrachten elektrisch leitfähigen Schichten sofort erkennbar sind. Dies trifft insbesondere auf die Verwendung in Sicherheitsmerkmalen für Datenträger, Wertdokumente und Produkten aller Art zu, insbesondere aber auch auf technische Anwendungen wie Displayfrontelektroden, Heizeinrichtungen Solarzellen, Schaltkreise und dergleichen.

Aus EP 0 426 801 B sind beispielsweise Sicherheitselemente für Sicherheitsdokumente bekannt, die Zeichen aufweisen, die im Auflicht verborgen sind, im Durchlicht erkennbar werden und die außerdem elektrisch leitend ausgeführt sind, wobei das elektrisch leitende Material vollflächig über mindestens eine Oberfläche des Sicherheitselementes vorhanden ist und zumindest in Teilbereichen transparent oder semitransparent ausgeführt ist und über und/oder unter den Zeichen angeordnet ist. Das elektrisch leitfähige Material befindet sich immer an der Oberfläche des Sicherheitsmerkmals.
Dabei wird das transparente bzw. semitransparente Material entweder durch eine Indium-Zinn-Oxidschicht oder durch Aufsputtern einer Metallschicht, insbesondere einer Aluminiumschicht realisiert.

Insbesondere für technische Anwendungen sind aber für eine sichere Funktion und Störungsunempfindlichkeit der elektrisch leitenden Schichten gewisse Anforderungen an die elektrisch leitende Schicht zu stellen, insbesondere was den elektrischen Widerstand, die mechanische Beständigkeit, die Flexibilität, die Dehnbarkeit, die Temperatur- und Chemikalienbeständigkeit betrifft, die mit den bekannten Lösungen nicht zufriedenstellend erreicht werden kann. Insbesondere bei der Verwendung in Displayfrontelektroden, Solarzellen, Schaltkreise und dergleichen ist auch Schutz gegen statische Aufladungen ein wesentliches Erfordernis.

Aufgabe der Erfindung ist daher die Bereitstellung von Substraten mit unsichtbaren, vorzugsweise transparenten, elektrisch leitfähigen Schichten, die zusätzlich die oben genannten gewünschten Eigenschaften aufweisen.

Gegenstand der Erfindung sind daher Substrate für technische Anwendungen mit mindestens einer elektrisch leitenden Schicht, dadurch gekennzeichnet, dass die elektrisch leitende Schicht(en) aus Polythiophen oder dessen Derivaten besteht.

Ein weiterer Gegenstand der Erfindung ist ein Verfahren zur Herstellung von Substraten mit mindestens einer elektrisch leitenden Schicht für technische Anwendungen, dadurch gekennzeichnet, dass ein Monomer oder Vorpolymer auf das Trägersubstrat aufgebracht und in situ polymerisiert wird, wobei der Initiator und/oder Katalysator ebenfalls in situ entfernt werden kann oder die Polymere als Dispersion auf das Trägersubstrat aufgebracht werden.

Als elektrisch leitfähiges Polymer wird vorzugsweise Polyethylendioxythiophen/Toluolsulfonat oder Polyethylendioxythiophenmethanol verwendet.

Das Polymer kann in Form einer Dispersion oder in Form des Monomers bzw. Vorpolymers mit nachfolgender Aufbringung eines Initiator und/oder Katalysator und/oder Katalysators oder bereits in Mischung mit einem Initiator und/oder Katalysator und/oder Katalysator auf ein Trägersubstrat aufgebracht werden.
Die Aufbringung des elektrisch leitfähigen Monomers bzw. Polymers kann auf jede bekannte konventionelle Weise erfolgen, beispielsweise durch Spin-Coating, Aufstreichen, Aufdampfen, durch Drucken, (Tiefdruck, Flexodruck, Siebdruck, Offsetdruck, Digitaldruck und dergleichen) durch Aufsprühen, Sputtem oder Walzenauftragstechniken.

Als Trägersubstrate kommen beispielsweise Trägerfolien, vorzugsweise flexible transparente Kunststofffolien, beispielsweise aus PI, PP, MOPP, PE, PPS, PEEK, PEK, PEI, PAEK, LCP, PEN, PBT, PET, PA, PC, COC, POM, ABS, PVC in Frage.
Die Trägerfolien weisen vorzugsweise eine Dicke von 5 - 700 µm, bevorzugt 5 - 200 µm, besonders bevorzugt 15 - 50 µm auf.

Ferner können als Trägersubstrat auch Metallfolien, beispielsweise Al-, Cu-, Sn-, Ni-, Fe- oder Edelstahlfolien mit einer Dicke von 5 - 200 µm, vorzugsweise 10 bis 80 µm, besonders bevorzugt 20 - 50 µm dienen. Die Folien können auch oberflächenbehandelt, beschichtet oder kaschiert beispielsweise mit Kunststoffen oder lackiert sein.

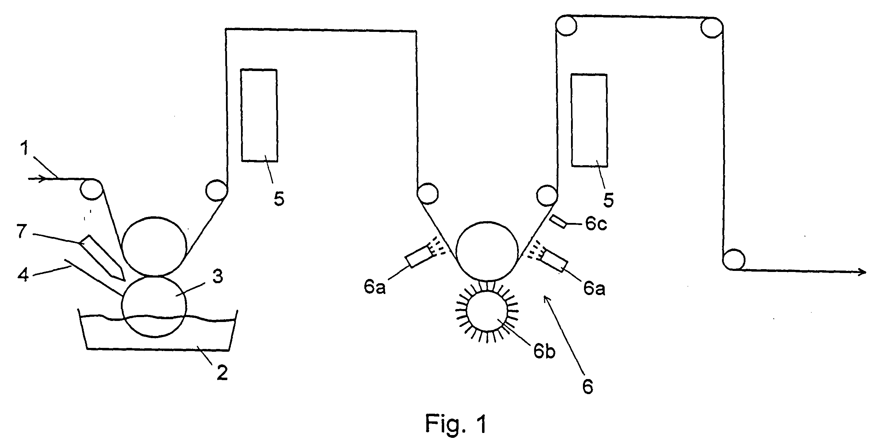

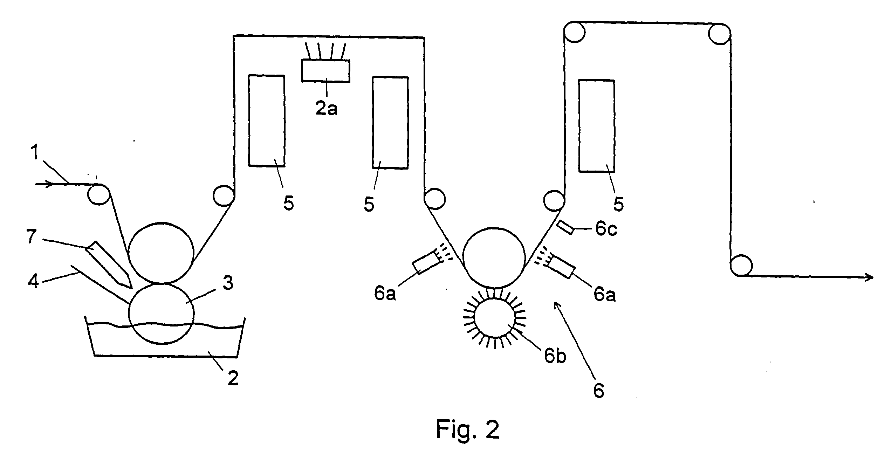

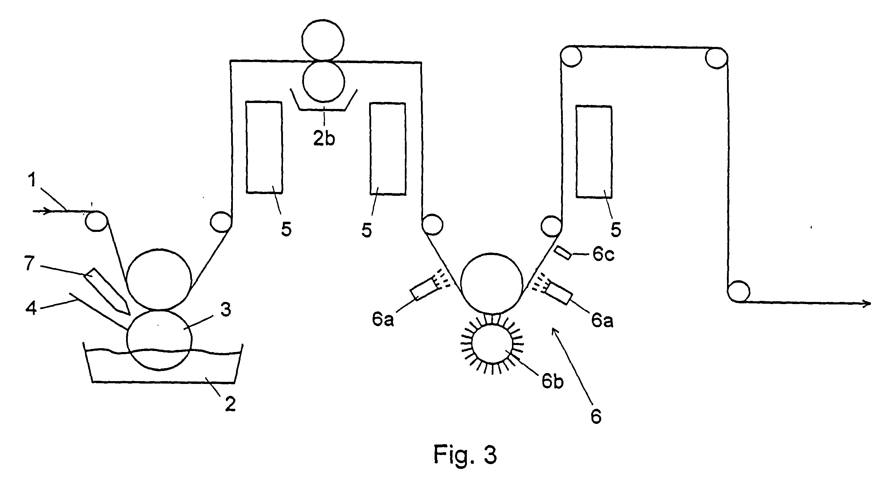

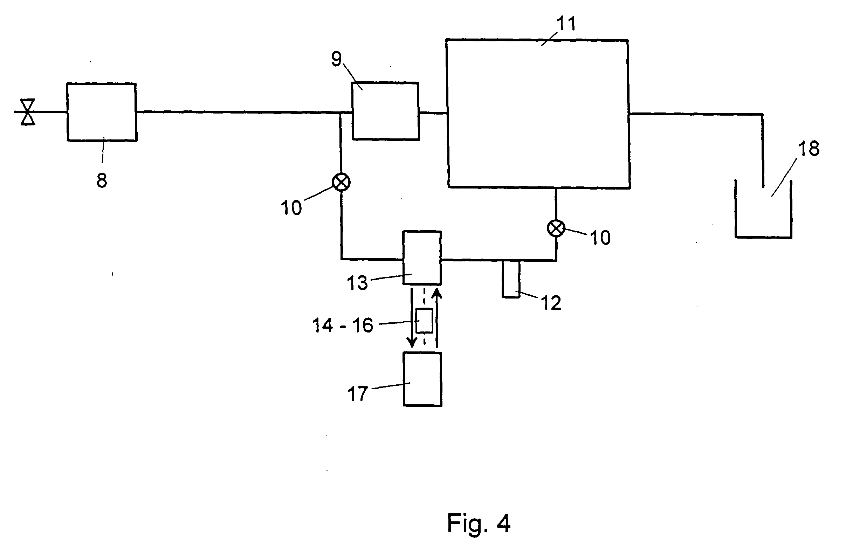

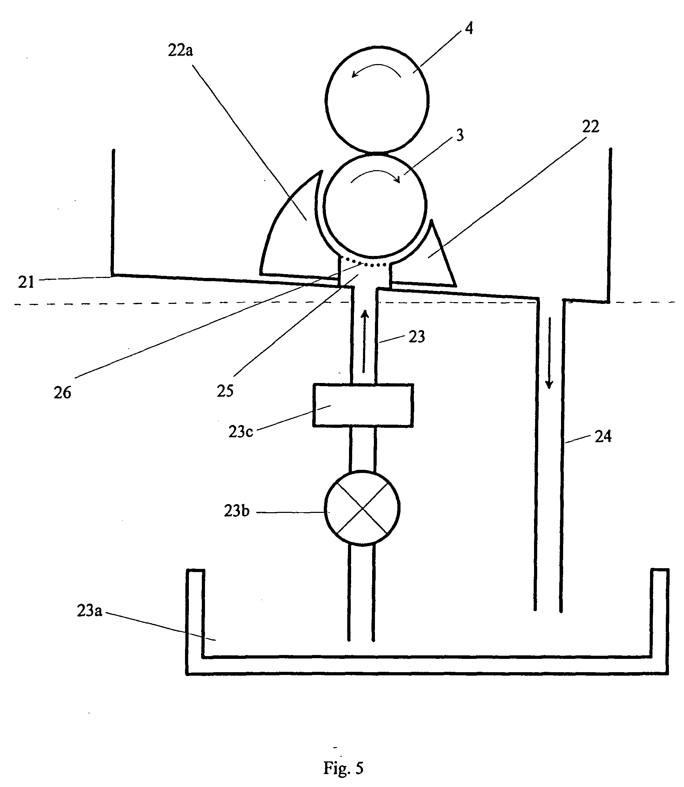

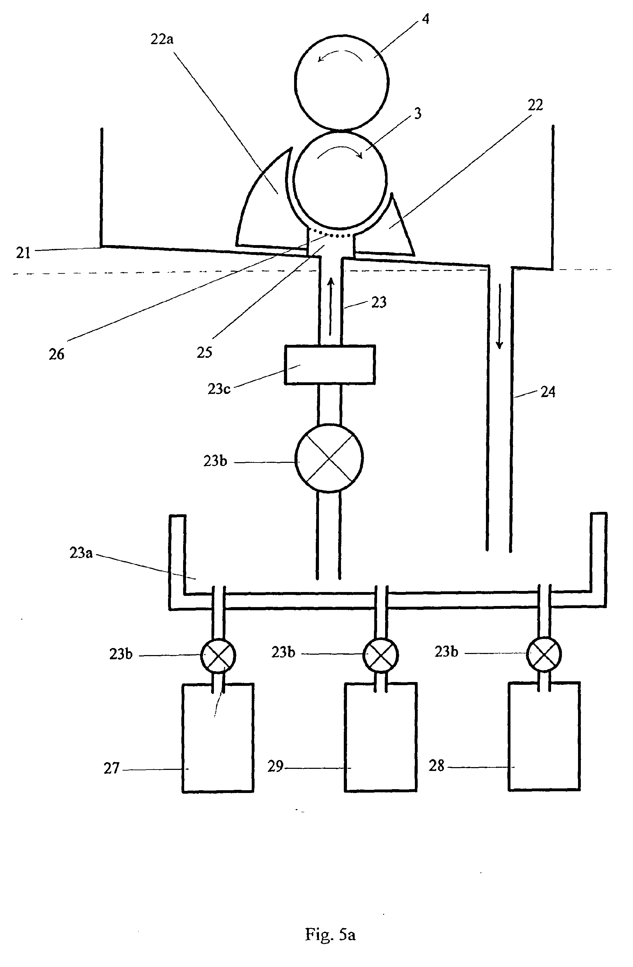

In Fig.1 ist eine spezielle Anordnung zur Aufbringung der leitfähigen Polymere (als Dispersion der Polymeren oder als Mischung von Monomer und Initiator und/oder Katalysator und/oder Katalysator) dargestellt. In Fig.2 ist eine weitere Möglichkeit der Aufbringung des Monomeren und des Initiator und/oder Katalysator und/oder Katalysator dargestellt, in Fig.3 eine Möglichkeit zur Aufbringung zweier aufeinanderfolgender Schichten des elektrisch leitfähigen Polymers, in Fig. 4 ein Schema zur Aufbereitung der Waschflüssigkeit und in Fig. 5 und Fig. 5a eine erfindungsgemäße Ausgestaltung der Aufbringungsvorrichtung mit Vorratsbehälter und getrennten auch als Zudosiereinheiten vorgesehenen Vorratsbehältern.

In den Fig. 1 bis 3 bedeutet 1 das Trägersubstrat, 2 ein Vorratsgefäß für die Polymerlösung bzw. -dispersion, bzw. für die Mischung des Monomeren mit dem Katalysator oder des Monomeren, 2a die Aufbringungsvorrichtung für den Katalysator (wenn im Vorratsgefäß 2 nur das Monomer bereitgestellt wird), 2b das Vorratsgefäß für die Aufbringung der zweiten Polymerschicht, 3 eine Übertragswalze, 4 eine Rakel, 5 eine Trocknereinrichtung (IR-, UV- oder Konvektionstrockner), 6 den Waschbereich mit folgenden gleichzeitig oder alternativ verwendbaren Einheiten 6a Spritzdüsen, 6b eine Bürste oder ein Filz und 6c ein Luftrakel und 7 eine optionale Blasleiste oder einen Trockner.
In Fig. 4 bedeutet 8 die Wasseraufbereitung (auch Zudosieren von Ionen in Form von Salzen), 9 eine Drucksteuerung, 10 eine Pumpe, 11 den Waschprozess, 12 einen Filter, 13 - 17 Ionentauscher, 18 die Abwasserentsorgung.

In den Fig. 5 und 5a ist eine bevorzugte Auftragsvorrichtung (2 bzw. 2b, und 3 wie in den Fig. 1 - 3 dargestellt) mit zugehörigem im folgenden näher beschriebenen zusätzlichen Tauchzylinder 3a dargestellt. In der bevorzugten Auftragsvorrichtung besteht das Vorratsgefäß 2 bzw. 2b aus einer Außenwanne 21 und einer Innenwanne 22 mit einem Rücklaufblech 22a. 23 bedeutet den Zulauf der Monomer/Initiator und/oder Katalysator und/oder Katalysatormischung aus einem Vorrats(misch)behälter 23a über eine Pumpe 23b und einen Filter 23 c, 24 bedeutet den Abfluss der Monomer/Initiator und/oder Katalysator und/oder Katalysatormischung aus der Außenwanne 22 in den Vorratsbehälter. 3a bedeutet einen Tauchzylinder und 3 den Übertragszylinder. 25 bedeutet einen Verteilertunnel für die Monomer/Initiator und/oder Katalysator und/oder Katalysatormischung, 26 das Verteilerblech des Verteilertunnels.

In Fig. 5a bedeutet 27 den Vorratsbehälter für das Monomer und 28 den Vorratsbehälter für den Initiator und/oder Katalysator und 29 den Vorratsbehälter für das Lösungsmittel.

Das Polymere kann in Form einer Dispersion in einem Dispersionsmittel auf das Trägermaterial aufgebracht werden. Als handelsübliche elektrische leitfähige Polymersuspension ist beispielsweise Baytron® MOH der Fa Bayer einsetzbar. (Fig.1 bzw. 5). Als Dispersionsmittel kommen beispielsweise inerte Lösungsmittel, vorzugsweise wässrige Lösungsmittel oder Alkohole, wie i-Propanol in Frage. Gegebenenfalls können den Polymerdispersionen auch Matrixpolymere, beispielsweise wasserlösliche Polyester, Polyurethane, Polystyrolsulfonate, Polyacrylate oder Ethylenacrylatcopolymere als Matrixpolymere zugesetzt werden.
Beispielsweise kann Polyethylendioxythiophen mit Polystyrolsulfonat als Matrixpolymer verwendet werden.

Die Partikelgröße der Polymere in der Dispersion beträgt vorzugsweise 20 - 500 nm.

Dabei wird vorzugsweise wie in Fig. 5 dargestellt aus einem Vorratsbehälter 23a, der vorzugsweise doppelwandig ausgeführt ist und temperaturgeregelt ist um eine entsprechende Temperatur die Polymerdispersion einzustellen, über eine Pumpe 23 b und einen Filter 23c in die temperaturkontrollierte Innenwanne 22 des Vorratsbehälters 2 (aus Fig. 1) gefördert. In der Innenwanne wird die Dispersion über einen Verteilertunnel 25 und das Verteilerblech 26, das mit regelmäßig angeordneten Öffnungen versehen ist, gleichmäßig verteilt.

Durch den Filter wird vermieden, dass Polymerpartikel in agglomerierter Form aufgetragen werden. Die Maschengröße des Filters bestimmt sich demgemäß nach der Partikelgröße des Polymeren in der Dispersion. Gleichzeitig werden auch mögliche Verunreinigungen zurückgehalten.

Die Innenwanne hat an der inneren Oberfläche die Form eines etwa Halbzylinders, wobei diese Oberfläche so dimensioniert ist, dass der Tauchzylinder 3a in einem definierten konstanten Abstand zur Innenoberfläche des Vorratsbehälters 2 eingreifen kann. Je nach Höhe der Füllung in der Innenwanne 22 greift der Tauchzylinder 3a mit etwa 1/3-1/2 seines Umfangs in die in die Innenwanne geförderte Dispersion ein. Die temperaturkontrollierte Innenwanne ist dabei so dimensioniert, dass sie auf der vom Abfluss 24 der umgebenden temperaturgeregelten Außenwanne abgewandten Seite in über die Dimension eines Halbzylinders, allerdings dessen Form im wesentlichen fortsetzendes Rücklaufblech bis zu einen Höhe von zumindest der Hälfte des Durchmessers bis zu etwa 2/3 des Durchmessers des Tauchzylinders aufweist.

Der Tauchzylinder nimmt nun die Polymerdispersion aus der Innenwanne und überträgt sie auf den Übertragszylinder. Dabei läuft nun die überschüssige Dispersion, die nicht vom Übertragszylinder aufgenommen wird, über die Außenseite der Innenwanne in die Außenwanne 21 zurück. Ebenso läuft jener Polymerdispersionsanteil, der über die Rakel 4 (in Fig.5 nicht dargestellt) nicht auf das Auftragswerkzeug aufgebracht wurde, in die Außenwanne zurück.

Aufgrund der Ausrichtung der Außenwanne nicht plan in einer Ebene, sondern mit einem leichten Gefälle von der dem Abfluss abgewandten Seite der Lackwanne zu der Seite auf der der Abfluss situiert ist, wird die in der Außenwanne 21 aufgefangene Dispersion aus dem gesamten Lackauftragswerk wieder zurück in den Vorratsbehälter 23a geführt. In der Innenwanne befindet sich also immer nur aus dem Vorratsbehälter unter definierter Temperatur und mit der über die Pumpe 23 b definierten Zuflussgeschwindigkeit eingebrachte Polymerdispersion.

Durch die Vermeidung des Rücklaufs von nicht über die folgenden Zylinder und die Rakel aufgebrachter Polymerdispersion in die Innenwanne wird dabei die Temperatur der Polymerdispersion in der Innenwanne korrekt konstant gehalten auch Lufteintrag vermieden. Ferner kann die Temperatur der Polymerdispersion in der Innenwanne ständig über einen Temperatursensor (in Fig.5 nicht dargestellt) kontrolliert werden.

Anschließend erfolgt die Trocknung der aufgebrachten Dispersion durch die die Trocknereinrichtungen 5 bzw. der Waschvorgang in der Waschstation 6 zur Entfernung von Lösungsmittelresten (Fig.1)

Es werden aber bevorzugt das Monomer bzw. Vorpolymer zur Bildung der elektrisch leitfähigen Polymere aufgebracht und in situ polymerisiert (Fig. 2, 3, und 5a).
Dabei können als Initiator und/oder Katalysator sowohl radikalische, als auch Redox- oder Photo-Initiator und/oder Katalysatoren und/oder -Katalysatoren, beispielsweise UV-, verwendet werden.

Sowohl Monomer als auch Initiator und/oder Katalysator und/oder Katalysator werden bevorzugt in einem Lösungs- bzw. Dispersionsmittel bereitgestellt, beispielsweise in einem Alkohol, wie Propanol oder n-Butanol.

Gegebenenfalls kann zusätzlich ein Katalysator zur Beschleunigung der Reaktion zugesetzt werden, beispielsweise ein Ziegler-Natta- Katalysator, oder ein Pt - Katalysator, wobei dann gegebenenfalls die zugesetzte Menge an Initiator und/oder Katalysator geringer sein kann.

In einer Ausführungsform kann, wie in Fig.2 dargestellt, das Monomer im Vorratsgefäß 2 bereitgestellt und ggf. analog der in Fig. 5 dargestellten Ausführungsform der Auftragsvorrichtung auf das Trägersubstrat aufgebracht werden. Der Initiator und/oder Katalysator und/oder Katalysator bzw. ggf. der zusätzliche Katalysator wird in Vorratsgefäß 2a bereitgestellt und auf das auf dem Trägersubstrat befindliche Monomer aufgetragen, wobei vorzugsweise ein Überschuss an Initiator und/oder Katalysator und/oder Katalysator aufgetragen wird um eine vollständige Polymerisation des Polymers zu erzielen, wie in der nachfolgenden besonders bevorzugten Ausführungsform näher beschrieben.

Nach der Polymerisation erfolgt wiederum der Trocknungsvorgang, der Waschvorgang und ggf. ein weiterer Trocknungsvorgang (wie in der nachfolgenden besonders bevorzugten Ausführungsform des erfindungsgemäßen Verfahrens näher beschrieben)

In der besonders bevorzugten Ausführungsform wird das entsprechende Monomer bzw. Vorpolymer vorzugsweise mit dem Initiator und/oder Katalysator Und/oder Katalysator (und gegebenenfalls mit einem zusätzlichen Katalysator) gemischt und auf das Trägersubstrat aufgetragen (analog Fig. 1, wobei im Vorratsgefäß 2 die Monomer/Initiator und/oder Katalysatormischung bereitgestellt wird).

Die bevorzugte Ausführungsform der Auftragsvorrichtung weist dabei, wie in Fig. 5a dargestellt, zusätzlich zu den in Fig. 5 dargestellten Elementen jeweils einen Vorratsbehälter für das Monomer und einen getrennten Vorratsbehälter für den Initiator und/oder Katalysator bzw. die Initiator- und/oder Katalysator bzw. zusätzlich Katalysatormischung und für das ggf. zusätzlich zuzudosierende Lösungsmittel auf. Vorzugsweise wird das Lösungsmittel über einen Viskositätsregler zudosiert.
Es ist auch möglich in einem Vorratsbehälter eine Lösung von Monomer bzw. Vorpolymer und Initiator und/oder Katalysator bereitzustellen und in einem zweiten Vorratsbehälter das ggf. zuzudosierende Lösungsmittel.
Die Monomer/Initiator- und/oder Katalysatormischung liegt dann in diesem Fall in (stark) verdünnter Lösung vor.

Besonders bevorzugt wird als Initiator/Katalysator Fe(III)toluolsulfonat verwendet. Fe(III)toluolsulfonat ist ein radikalischer Initiator bzw. Katalysator, der zugleich eine Redoxreaktion bei der Polymerisation initiiert. Das Fe(III)-Ion wirkt als Initiator und das Toluolsulfonat bestimmt als Gegenion die Konfiguration des Polymers.

Wird also Ethylendioxythiophen-methanol als Monomer, beispielsweise Baytron® M OH, und Fe(III)toluolsulfonat, beispielsweise Baytron® C- Typen, beispielsweise Baytron® CB-40 der Fa Bayer, als Initiatorund/oder Katalysator verwendet, ist das auf dem Trägersubstrat nach der Polymerisation vorhandene Polymer Polyethylendioxythiophen-methanol.

Um eventuelle störende Rückstände in der leitfähigen Schicht zu vermeiden wird der Initiator und/oder Katalysator, also insbesondere Fe(III)toluolsulfonat, z.B. Baytron® CB 40, der Fa. Bayer in großem Überschuss im Vergleich zum Monomer resp. Vorpolymer (z.B. Ethylendioxythiophen-methanol, wie Baytron® M OH der Firma Bayer) eingesetzt. Das Gewichtsverhältnis von Monomer bzw. Vorpolymer zu Initiator und/oder Katalysator beträgt dabei etwa 1:20 - 1:100, bevorzugt 1:30 bis 1:80. Der Überschuss an Initiator und/oder Katalysator gewährleistet eine vollkommene und sichere Umsetzung des gesamten Monomers auch während kürzerer verfügbarer Reaktionszeiten, womit sichergestellt ist, dass keine gesundheitsschädlichen Reste zurückbleiben. Weiters wird durch diesen Überschuss an Initiator und/oder Katalysator eine optimale Filmbildung erreicht.

Bei dem erfindungsgemäßen Verfahren werden also die Reinstoffe (Monomer, Initiator und/oder Katalysator) ohne Zusatz weiterer Bindemittel und/oder Additive eingesetzt.

Die Polymerisation erfolgt in Abhängigkeit vom verwendeten Lösungsmittel bereits zu dem Zeitpunkt, in dem eine Temperatur erreicht wird, die ein Abdampfen des Lösungsmittels bewirkt. Um eine vorzeitige bzw. zu starke Polymerisation vor der Aufbringung auf das Trägersubstrat in den Vorratsgefäßen, bzw. eine zu rasche Polymerisation unmittelbar nach der Aufbringung auf das Trägersubstrat zu vermeiden, wird in Abhängigkeit von der in den Vorratsgefäßen herrschenden Temperatur vorteilhafterweise aus den vorgesehenen Vorratsbehältern Monomer bzw. Lösungsmittel je nach Bedarf über eine Pumpe nachdosiert, wobei bei der Zudosierung des Lösungsmittels (beispielsweise ein Alkohol, wie Propanol oder n-Butanol) darauf geachtet werden sollte, dass nach der Polymerisation nicht große Mengen an Lösungsmittel in der Schicht verbleiben, die anschließend entfernt werden müssen, also eine ausgeglichene Zudosierung erfolgt. Vorzugsweise wird die unerwünschte Polymerisation aber durch Zudosieren des im Lösungsmittel stark verdünnt vorliegenden Monomers gesteuert

Alternativ kann eine frühzeitige Polymerisation auch durch die exakte Kontrolle der Temperatur in den Vorratsbehältern und im Auftragswerk verhindert werden, wobei Tauchzylinder bzw. Übertrags- und Auftragszylinder ggf. gekühlt bzw. beheizt werden sollten.

In einem entsprechend den Fig. 5 und 5a ausgestalteten Auftragswerk wird daher durch Einstellung der Verhältnisse der Mischungskomponenten bzw. der Temperatur die Reaktionskinetik gesteuert und gleichzeitig ein gleichmäßiger homogener Auftrag der Polymerdispersion bzw. der Monomerlösung bzw. der Monomer/Initiator- und/oder Katalysatormischung erreicht.

Je nach verwendetem Lösungsmittel findet die Polymerisation bei Temperaturen von 50 -150°C, bevorzugt bei 80 - 120°C statt.

Initiator- und/oder Katalysatorüberschuss und ggf. Katalysatorreste und andere verunreinigende Reaktionsprodukte können dabei ebenfalls in situ entfernt werden oder gegebenenfalls anschließend durch Behandlung mit einem Lösungsmittel, beispielsweise Wasser, entsalztes Wasser, entionisiertes Wasser, Alkohole, wie Ethanol, Propanole, Butanole und dergleichen oder Wasser/Lösungsmittelgemische aus der Schicht entfernt werden.

Bevorzugt wird der Initiator und/oder Katalysatorüberschuss durch Wasser entfernt, das beispielsweise durch Umkehrosmose, Ionentauscher, Destillation oder physikalische Wasseraufbereitungsanlagen aufbereitet wird.

Die Reaktion kann während des Waschprozesses durch eine definierte Einstellung des lonengehalts des Wassers, insbesondere des Gehalts an Alkali-und/oder Erdalkali-Ionen noch beeinflusst werden. Durch Anlagerung der im Wasser vorhandenen Ionen an die O-Atome der Ethylendioxythiophen-Einheiten bilden sich Komplexe, wodurch die Konfiguration der Makromoleküle verändert wird und damit die Bandlücke im Absorptionsspektrum und somit das Absorptionsmaximum verschoben wird.
Gleichzeitig ist durch diese Komplexbildung auch die Leitfähigkeit veränderbar und kann daher durch den Gehalt an Ionen im Wasser definiert eingestellt werden.

Das wie oben beschrieben aufbereitete Wasser wird daher gegebenenfalls durch Zugabe von Alkali- und/oder Erdalkali-Ionen in Form von Salzen, beispielsweise Na-salzen, beispielsweise NaCl oder Erdalkalisalzen wie Mg-Salzen, wie beispielsweise MgCl₂ auf einen definierten lonengehalt eingestellt.

Der Waschvorgang erfolgt vorzugsweise durch Aufbringen der gewählten Waschflüssigkeit mittels eines oder mehrerer Düsenbalken, wobei vorzugsweise Druck und Winkel der auf die Beschichtung auftreffenden Waschflüssigkeit einstellbar sind.

Das überschüssige Wasser auf der Polymerbeschichtung wird durch abquetschen, abwischen, abtrocknen, durch geeignete Vorrichtungen, wie Abquetschvorrichtungen, Trockenvorrichtungen, Luftrakel, oder Absaugeinheiten entfernt und in einen Recyclierungskreislauf geführt.

Das aus dem Prozess abfließende Wasser wird vorzugsweise im Kreis geführt, wobei je nach Bedarf gegebenenfalls Frischwasser zudosiert werden kann. Mit Initiator bzw. Initiator und Katalysator gesättigtes Abwasser wird über ein Filtersystem und anschließend über Ionenaustauscher und/oder durch Destillation aufbereitet. Um einen kontinuierlichen Betrieb zu gewährleisten, kann weiters bevorzugt eine Gruppe vom mehreren, bevorzugt 1 - 5 Ionentauschern verwendet werden, wobei beispielsweise mindestens ein Ionentauscher in Betrieb ist, ein weiterer im Stand-by-Modus und ein weiterer im Regenerationsmodus.

Gegebenenfalls kann abschließend ein Waschvorgang mit reinem, wie oben beschrieben aufbereitetem, Frischwasser angeschlossen werden.

Leicht flüchtige Bestandteile können im Anschluss gegebenenfalls auch durch Trocknen mit einem IR-Trockner, einem Konvektionstrockner und dergleichen entfernt werden.

Die elektrisch leitfähigen Polymerschichten können je nach Verwendung jeweils eine Dicke von 0,1 - 50 µm, vorzugsweise 0,5 - 10 µm aufweisen. Für bestimmte Verwendungen sind dünnere Schichten von 0,001 - 50 µm, bevorzugt 0,05 - 10 µm ohne weiteres herstellbar.

Ferner sind die erfindungsgemäßen Schichten ausgezeichnet leitfähig. Die Dehnbarkeit der Schicht kann in Abhängigkeit vom Polymerisationsverfahren variabel gesteuert werden.

Die elektrisch leitfähigen polymeren Schichten sind im allgemeinen temperaturbeständig, es können ggf. Temperaturbeständigkeiten von >100° C erreicht werden.

Mit den erfindungsgemäßen elektrisch leitenden Polymerschichten kann gewünschtenfalls eine Transparenz von > 80% erreicht werden.

Die elektrisch leitfähigen Polymere können auch pigmentiert sein, wobei alle bekannten Pigmente geeignet sind, Soll die Transparenz nicht deutlich beeinflusst werden, sind allerdings stark deckende bzw. färbende Pigmente wie Ruß oder Graphit nicht geeignet.

Der Anteil an Pigmenten im Festkörper kann bis zu 40% betragen.

Gegebenenfalls kann das Trägermaterial vorher zur Verbesserung der Haftung des verwendeten leitfähigen Polymers mit einem Haftvermittler behandelt werden. Im allgemeinen ist jedoch insbesondere bei der Verwendung der in situ Polymerisation der Monomere bzw. Vorpolymere die Haftung der elektrisch leitfähigen Polymere auf allen Trägersubstraten durchaus mehr als befriedigend.

Die elektrisch leitfähigen Polymere können sowohl vollflächig als auch partiell auf dem Trägermaterial vorhanden sein.

Die Aufbringung der elektrisch leitfähigen Polymeren nach einer der beschriebenen Ausführungsformen des Verfahrens in Form von Zeichen und Mustern, flächigen oder linienförmigen, wellenförmigen oder zickzackförmigen und ähnlichen oder analogen Strukturen, wie beispielsweise Guillochen, längs und/oder quer zur Maschinenrichtung des Substrats erfolgen.

Linienförmige oder analoge Strukturen haben eine in einer Vorzugsrichtung entsprechend der Ausrichtung der Strukturen gerichtete Leitfähigkeit. Außerdem gewährleisten diese Strukturen eine zusätzliche Sicherheit gegenüber Zerstörung durch Querrisse in dieser und ggf. darüber- und/oder darunterliegenden Schicht, da diese an den Zwischenräumen am Weiterreißen gehindert werden. Wird eine derartige elektrisch leitfähige Schicht durch eine zusätzliche Schicht, beispielsweise eine Lackschicht oder durch Kaschieren geschützt, gewährleisten die Zwischenräume bzw. Aussparungen eine verbesserte Versieglung der leitfähigen Polymerschicht.
Diese Strukturen stellen gegebenenfalls auch eine 2-dimensionale Codierung dar.

Da die elektrisch leitfähigen polymeren Schichten zwar mechanisch und thermisch sehr beständig sind, aber ggf. feuchtigkeitsempfindlich sein können, liegen diese Schichten bevorzugt nicht direkt an der Oberfläche des Substrats.

In einer Ausführungsform können beispielsweise linien- wellenförmige oder zickzackförmige Strukturen oder Guillochen zur Erhöhung des Leitungsquerschnitts über Querverbindungen, die unterschiedliche Breiten oder Formen aufweisen können und ggf. auch in unterschiedlichen Winkeln zur Grundstruktur angeordnet sein können, verbunden sein.

Die Breiten der Linien, Wellen oder zickzackförmigen Strukturen oder Guillochen können beispielsweise 0,05 - 10 mm, bevorzugt 0,1 - 0,3 mm, die der Querverbindungen 0,5 bis 100 mm, bevorzugt 1 bis 10 mm betragen.

Die Aufbringung der elektrisch leitfähigen Monomeren bzw. Polymere kann auf jede bekannte konventionelle Weise erfolgen, beispielsweise durch Spin-Coating, Aufstreichen, Aufdampfen, durch Drucken, (Tiefdruck, Flexodruck, Siebdruck, Offsetdruck, Digitaldruck und dergleichen) durch Aufsprühen, Sputtern oder Walzenauftragstechniken.

Zur partiellen Aufbringung kann eine in einem Lösungsmittel lösliche Farbe oder ein löslicher Lack auf das Trägersubstrat oder etwaige bereits darauf befindliche Schichten aufgebracht werden. Anschließend wird das leitfähige Polymer auf diese Schicht aufgebracht, worauf die lösliche Farbe in den nicht beschichteten Bereichen mit Hilfe des geeigneten Lösungsmittels, gegebenenfalls mit mechanischer Unterstützung entfernt wird.

Es kann aber auch zuerst ein entsprechender Haftvermittler partiell in der gewünschten Form auf das Trägersubstrat aufgebracht werden, anschließend vollflächig das elektrisch leitfähige Polymer aufgetragen werden, worauf das Polymer in jenen Bereichen, in denen kein Haftvermittler vorhanden ist, durch entsprechende Maßnahmen, die auf die Grundhaftfähigkeit des elektrisch leitfähigen Polymers abgestimmt sind, wieder abgelöst werden kann.

Weiters kann die partielle Aufbringung auch nach dem in der DE 100 25 522 A1 beschriebenen Verfahren erfolgen.

Die elektrisch leitfähige Polymerschicht kann aber auch haftend oder releasefähig eingestellt werden.

Um die Leitfähigkeit zu erhöhen ist es auch möglich, vorerst eine Schicht aus dem elektrisch leitfähigen Polymer aufzubringen und anschließend eine weitere Schicht des elektrisch leitfähigen Polymers beispielsweise durch in-situ Polymerisation aufzubringen. Ferner können die erfindungsgemäßen elektrisch leitfähigen Polymerschichten auch in Verbindung mit einer anorganischen vorzugsweise metallischen oder pigmentierten leitfähigen Schicht besonders vorteilhaft aufgebracht werden. Dabei erfolgt nicht nur eine Verbesserung der elektrischen leitenden Eigenschaften des beschichteten Substrat sondern auch eine zusätzliche Sicherung der einwandfreien Funktion und Identifizierbarkeit.

Aufgrund der besseren Dehnbarkeit der elektrisch leitfähigen Polymere können Funktionsstörungen, die durch feine und feinste Risse in der anorganischen leitfähigen Schicht auftreten können, durch die elektrisch leitfähige Polymerschicht überbrückt werden.

Ein Mehrschichtaufbau einer vollflächigen oder partiellen Schicht eines leitfähigen Polymeren mit darüber gedruckten linienförmigen, wellenförmigen und dergleichen Strukturen desselben Polymers führt zu unterschiedlichen Leitfähigkeiten in den verschiedenen Richtungen, beispielsweise parallel oder quer zur Maschinenrichtung, aber auch in jedem beliebigen Winkel zur Maschinenrichtung.

Wird die vollflächige polymere leitfähige Grundschicht beispielsweise durch einen entsprechenden tiefenvariablen Tiefdruckzylinder, in unterschiedlicher Dicke ausgeführt, werden dabei winkelabhängige Leitfähigkeiten erreicht.

Die polymere leitfähige Grundschicht und die zweite darüber aufgebrachte polymere leitfähige Schicht können gegebenenfalls auch durch eine Isolatorschicht getrennt sein.

Es sind aber auch Aufbauten aus mehr als 2 jeweils vollflächigen und/oder partiellen polymeren elektrisch leitfähigen Schichten, die ggf. durch Isolatorschicht(en) getrennt sein können denkbar.

Bevorzugt liegt/liegen die elektrisch leitfähige(n) (polymere(n)) Schicht(en) nicht in direktem Kontakt zu metallischen Schichten und wird (werden) von diesen durch eine Isolatorschicht getrennt.

Ferner können die elektrisch leitfähigen Polymerschichten, wie auch gegebenenfalls die zusätzlichen anorganischen metallischen und/oder pigmentierten elektrisch leitfähigen Schichten als Patches codiert und damit auch maschinenlesbar und/oder strukturiert aufgebracht werden. Ferner können die elektrisch leitfähigen Polymerschichten anschließend inline oder offline geprägt werden.
Die so hergestellten Substrate sind aufgrund ihrer Eigenschaften, nämlich hoher Transparenz, guter Leitfähigkeit und der Möglichkeit der Steuerung der gewünschten Leitfähigkeit durch das Herstellverfahren, der ausgezeichneten mechanischen Beständigkeit und Dehnbarkeit, der hohen Chemikalienbeständigkeit und der Möglichkeit mit dem beschriebenen Verfahren äußerst dünne Schichten einer Dicke von etwa 50 - 500 nm aufzubringen ausgezeichnet für technische Anwendungen, beispielsweise Displayfrontelektroden, unsichtbare Leiterbahnen, transparente elektromagnetische Abschirmung, transparente Frontelektroden, Kunststoffsolarzellen, OLEDS usw. geeignet.

### Beispiele:

### Beispiel 1:

Auf eine Trägerfolie aus PET mit einer Dicke von 50 µm, die bereits partiell mit einer optisch aktiven Schicht beschichtet ist, und auf die ein handelsüblicher Haftvermittler ( A 1120, Fa. OSI)) aufgebracht ist, wird aus einem Vorratsgefäß über eine Übertragswalze eine Dispersion von 2% Polyethylendioxythiophen-methanol (Partikelgröße 100 nm in der Dispersion) mit 2% Polystyrolsulfonat in Wasser/ i-Propanol als Dispersionsmittel vollflächig in einer Schichtdicke von 3 µm aufgebracht. Anschließend wird die aufgebrachte Polymerschicht bei 110°C getrocknet.

Die so hergestellte Folie weist eine Leitfähigkeit von 800Ω/square auf, die leitfähige Schicht weist eine Transparenz von 87 % auf

### Beispiel 2:

Auf die analog Beispiel 1 hergestellte Folie wird anschließend eine Mischung von Ethylendioxythiophen-methanol und Fe(III)toluolsulfonat als Initiator im Gewichtsverhältnis 1:60 bei einer Temperatur von 110°C im Tiefdruckverfahren aufgebracht und polymerisiert Diese Mischung polymerisiert in situ und wird anschließend zur Entfernung von Katalysatorrückständen mit Wasser behandelt. Anschließend wird die Schicht getrocknet und eine konventionelle Schutzlackschicht aufgebracht.

Die so hergestellte leitfähige Folie weist eine Leitfähigkeit von 220 Ω/square und die beiden leitfähigen Schichten zusammen weisen eine Transparenz von 82% auf.

Eine anschließend auf die Folie auf bekannte Weise partiell aufgebrachte fluoreszierende Lackschicht zeigt keinen Einfluss auf die Leitfähigkeit bzw. die Transparenz der freibleibenden Bereiche der leitfähigen Schichten.

### Beispiel 3:

Analog zu Beispiel 1 wird eine partielle Schicht hergestellt aus Baytron® M OH und Baytron® CB-40 im Gewichtsverhältnis 1: 60 gelöst in n-Butanol entsprechend dem in Fig. 1 und 5a beschriebenen Verfahren auf eine 6 µm Polyesterfolie aufgebracht.
Die partielle Schicht weist eine linienförmige Struktur von 0,1 mm Breite im Abstand von 0,1 mm auf.
Auf diese Schicht wird eine opake Druckfarbe partiell in Form von beliebigen Zeichen aufgebracht.
Anschließend wird das Substrat in Fäden einer Breite von 1 mm geschnitten, wodurch auf einem Faden durchschnittlich 5 Linienstrukturen vorhanden sind.
Die gerichtete Leitfähigkeit beträgt 215 Ω/square.

### Beispiel 4:

Die gemäß Beispiel 3 hergestellte Folie wird mit einer 10 µm PET - Folie mit einer 0,5 µm partiellen Schicht bestehend aus einer magnetischen Druckfarbe auf Basis von Fe₃O₄ in einer Acrylat-Polymerdispersion und einer 0,2 µm Schicht aus einer fluoreszierenden Druckfarbe mittels eines handelsüblichen Kaschierklebers kaschiert.

Anschließend wurden die Oberflächen mit einem Heißsiegellack versehen.

Die Leitfähigkeit betrug 215 Ω/square, die magnetischen Eigenschaften wurden mit 330 nW/m bei einer Koerzitivät von 250 Oerstedt bestimmt.

## Patentansprüche

1. Substrate für technische Anwendungen mit mindestens einer elektrisch leitenden Schicht, **dadurch gekennzeichnet, dass** die elektrisch leitende Schicht(en) aus Polythiophen/Toluoulsulfonat oder Derivaten des Polythiophen /Toluolsulfonat besteht

2. Substrate nach Anspruch 1, **dadurch gekennzeichnet, dass** die Schicht(en) aus dem elektrisch leitfähigen Polymeren partiell oder vollflächig auf dem Substrat vorhanden sind.

3. Substrate nach einem der Ansprüche 1 oder 2, **dadurch gekennzeichnet, dass** die Schicht(en) aus elektrisch leitfähigen Polymeren aus Polyethylendioxythiophen-methanol/Toluolsulfonat bestehen

4. Substrate nach einem der Ansprüche 1 - 3, **dadurch gekennzeichnet, dass** als elektrisch leitfähiges Polymer Polyethylendioxythiophen-methanol, das über ein nicht polymer gebundenes Anion stabilisiert ist, verwendet wird.

5. Substrate nach einem der Ansprüche 1 bis 4 **dadurch gekennzeichnet, dass** die elektrisch leitfähigen Polymerschichten eine Transparenz von > 80% aufweisen.

6. Substrate nach einem der Ansprüche 1 bis 5, **dadurch gekennzeichnet**, das die leitfähige(n) Polymerschicht(en) eine definierte einstellbare Leitfähigkeit aufweist/aufweisen.

7. Verwendung der Substrate gemäß einem der Ansprüche 1 - 6 für Displayfrontelektroden, unsichtbare Leiterbahnen, transparente elektromagnetische Abschirmung, transparente Frontelektroden, Kunststoffsolarzellen, OLEDS.
